# EUROPÄISCHE PATENTSCHRIFT

(11) **EP 2 671 433 B1**
(45) Veröffentlichungstag und Bekanntmachung des Hinweises auf die Patenterteilung: **17.05.2017**
(21) Anmeldenummer: 12701220.1
(22) Anmeldetag: 16.01.2012
(51) Int. Cl.: H05K 7/14, H05K 7/20

(54) **ELEKTRISCHES GERÄT**
ELECTRICAL DEVICE
APPAREIL ÉLECTRIQUE

(30) Priorität: 04.02.2011 DE 102011010434
(43) Veröffentlichungstag der Anmeldung: 11.12.2013
(73) Patentinhaber: Sew-Eurodrive GmbH & Co. KG, 76646 Bruchsal (DE)
(72) Erfinder: NIKOLA, Joachim, 76703 Kraichtal (DE); SCHÖRNER, Martin, 76646 Bruchsal (DE); KOLLAR, Hans, Jürgen, 76646 Bruchsal (DE); MOMANN, Dirk, 76646 Bruchsal (DE)
(86) Internationale Anmeldenummer: PCT/EP2012/000158
(87) Internationale Veröffentlichungsnummer: WO 2012/104016

(56) Entgegenhaltungen:
- WO-A1-99/59225
- DE-A1- 10 234 477
- US-A- 3 735 206
- US-A- 5 755 026

## Beschreibung

Die Erfindung betrifft ein elektrisches Gerät.
Es ist bekannt, dass Umrichter als Elektrogerät Signalelektronik und Leistungselektronik aufweisen. Dabei wird von der Leistungselektronik ein Verbraucher, wie Elektromotor, gespeist. Die Wärme, insbesondere die Wärme der Leistungshalbleiterschalter der Leistungselektronik, wird an einen Kühlkörper abgeführt und von dort an die Umgebungsluft oder ein anderes umgebendes Kühlmedium.
Zur Verbesserung von Wärmeübergängen ist es bekannt, Wärmeleitpaste in den Wärmeübergangsbereich einzubringen.

Aus der DE 102 34 477 A1 ist eine Leitungshalbleitervorrichtung bekannt.
Aus der US 3 735 206 A ist eine Leiterplattenanordnung bekannt.
Aus der US 5 755 026 A ist ein Verfahren zum Verhindern von Kondensation an einer Gehäuseoberfläche eines Elektrogerätegehäuseteils bekannt.
Aus der WO 99/59225 A1 ist ein Schaumgehäuse für eine Leiterplatte bekannt.
Der Erfindung liegt daher die Aufgabe zugrunde, ein elektrisches Gerät weiterzubilden, wobei die Fertigung einfach sein soll und der Umweltschutz verbessert sein soll.

Erfindungsgemäß wird die Aufgabe bei dem Gerät nach den in Anspruch 1 angegebenen Merkmalen gelöst.

Wichtige Merkmale der Erfindung bei dem elektrischen Gerät, sind, dass es eine Leiterplatte aufweist, die mit wärmeerzeugenden Bauteilen bestückt ist,
wobei die Leiterplatte in einem Gehäuse des Geräts angeordnet ist,
wobei ein Kunststoffkörper die Leiterplatte zumindest teilweise umschließt und mit der bestückten Leiterplatte verbunden ist, insbesondere stoffschlüssig und/oder formschlüssig.

Von Vorteil ist dabei, dass die Leiterplatte samt der bestückten Bauelemente geschützt ist vor mechanischen Einwirkungen, wie Kraftstößen, Erschütterungen oder dergleichen. Insbesondere sind auch herausstehende Bauteile gegen Schwingungen besser stabilisierbar mittels des Kunststoffkörpers. Somit ist eine sichere Transportfähigkeit und Lagerfähigkeit gewährleistbar, wobei die Leiterplatte nicht eingebaut ist im Gehäuse des Geräts. Bei wärmeleitender Ausführung des Kunststoffkörpers ist auch eine verbesserte Entwärmung der Wärme erzeugenden Bauelemente erreichbar.

Weiter ist der Umweltschutz verbessert, weil bei defekter Elektronik nur die Kassette auszutauschen ist. Das topfförmige Gehäuseteil ist wiederverwendbar und kann beim Austausch der Kassette in der Anlage installiert bleiben. Dies verringert auch den Reparaturaufwand.

Wichtige Merkmale bei dem elektrischen Gerät sind, dass es eine Leiterplatte aufweist, die mit wärmeerzeugenden Bauteilen bestückt ist,
wobei die Leiterplatte in einem Gehäuse des Geräts angeordnet ist,
wobei beidseitig der Leiterplatte ein Kunststoffkörper angeordnet ist und mit der bestückten Leiterplatte verbunden ist, insbesondere stoffschlüssig und/oder formschlüssig.

Von Vorteil ist dabei, dass der Kunststoffkörper die Leiterplatte umgibt und somit ein guter mechanischer Schutz gewährleistbar.

Bei einer vorteilhaften Ausgestaltung ist der Kunststoffkörper aus mindestens zwei miteinander formschlüssig verbundenen Teilkörpern zusammengesetzt, insbesondere wobei die formschlüssige Verbindung eine Verrastung ist. Von Vorteil ist dabei, dass die Teilkörper vorfertigbar sind und somit um die Leiterplatte anordenbar und miteinander verbindbar sind. Somit muss die Leiterplatte nicht belastet werden beim Anordnen der Teilkörper um die Leiterplatte herum.

Bei einer vorteilhaften Ausgestaltung ist der Kunststoffkörper einstückig ausgebildet, insbesondere als Umspritzung oder als Kunststoffgussteil hergestellt. Von Vorteil ist dabei, dass eine besonders kostengünstige Herstellung ausführbar ist, da die Leiterplatte nur in eine Werkzeugform eingebracht werden muss und dann umspritzbar oder umgießbar ist.

Bei einer vorteilhaften Ausgestaltung weist die bestückte Leiterplatte an ihrer Oberfläche einen Lack auf, insbesondere einen wasserdampfabweisenden Lack und/oder einen wasserabweisenden Lack. Von Vorteil ist dabei, dass die Leiterplatte in einer Werkzeugform mit Styroporkügelchen umgebbar und Wasserdampf hinzugebbar ist, so dass in einfacher Herstellungsweise eine Ummantelung mit Styropor produzierbar. Unter Styropor wird dabei auch jeder andere geschäumte Kunststoff verstanden, insbesondere welcher wärmeleitend und elektrisch isolierend ist und vorzugsweise einen Flammschutz-Zusatz aufweist.

Bei einer vorteilhaften Ausgestaltung ist der Kunststoff als Styropor oder als Schaumstoff, insbesondere als ein Polyurethanschaum, ausgeführt. Von Vorteil ist dabei, dass ein kostengünstiges Material verwendbar ist, das durch chemische Zusatzbestandteile mit verbesserter Wärmeleitfähigkeit ausstattbar ist.

Bei einer vorteilhaften Ausgestaltung weist der Kunststoff eine bessere Wärmeleitfähigkeit, insbesondere spezifische Wärmeleitfähigkeit, auf als Luft,
insbesondere wobei der Kunststoffkörper aus elektrisch isolierendem Werkstoff gefertigt ist. Von Vorteil ist dabei, dass durch entsprechende Zusätze die Wärmeleitfähigkeit verbesserbar ist. Außerdem ist somit Luft als Wärmetransportmittel verzichtbar und ein direktes Zwischenordnen des Kunststoffkörpers zwischen Leiterplatte und Kühlplatte ermöglicht. Das Elektrogerät ist ein Umrichter, wobei die Signalelektronik und die Leistungselektronik des Umrichters auf der Leiterplatte angeordnet ist. Von Vorteil ist dabei, dass nur eine Leiterplatte zu bestücken ist und somit eine hochautomatisierte Herstellung ermöglicht ist, da das Bestücken durch Bestückungsautomaten ausführbar ist. Außerdem ist das Verbinden der elektronischen Schaltung, also umfassend die Leiterplatte mit verbundener Kühlplatte, mit dem Gehäuse besonders einfache und leicht ausführbar, da nur ein Einschieben der elektronischen Schaltung ins topfförmige Gehäuse auszuführen ist.

Bei einer vorteilhaften Ausgestaltung ist auf der Leiterplatte ein Leistungsmodul angeordnet, welches mit einer Kühlplatte, insbesondere auf eine Aluminium enthaltendes Kühlplatte, verbunden ist,
insbesondere auf diese Kühlplatte aufgeschraubt ist und mit dieser wärmeleitend verbunden ist zur Abfuhr von Wärme. Von Vorteil ist dabei, dass bei Montage die Kühlplatte über das Leistungsmodul mit der Leiterplatte verbindbar ist. Somit ist mit dem Kunststoffkörper eine erste Seite der Leiterplatte schützbar, also die von der Kühlplatte abgewandte Seite der Leiterplatte, und es ist die andere Seite der Leiterplatte nicht nur durch den restlichen Teilkörper des Kunststoffkörpers schützbar sondern auch durch die Kühlplatte.

Bei einer vorteilhaften Ausgestaltung ist die Kühlplatte außerhalb des Kunststoffkörpers angeordnet, insbesondere wobei das Leistungsmodul durch eine Ausnehmung des Kunststoffkörpers hindurchragt. Von Vorteil ist dabei, dass die Wärmeableitung durch den ansonsten schützenden Kunststoffkörper nicht beeinträchtigt wird. Erfindungsgemäß weist der Kunststoffkörper Ausnehmungen für auf der Leiterplatte bestückte Bauteile, insbesondere für große Bauteile, auf. Von Vorteil ist dabei, dass in diesen Bereichen die Wärmeabfuhr an die Kühlplatte mittels Luft ausführbar ist oder - wie bei dem Leistungsmodul - durch eine Kontaktfläche an der Kühlplatte.

Bei einer vorteilhaften Ausgestaltung weist der Kunststoffkörper, insbesondere der zweite Teilkörper, eine weitere Ausnehmung auf, die eine Luftverbindung zwischen einem Wärme erzeugenden, auf der Leiterplatte bestückten Bauelement und einem Oberflächenteilbereich der Kühlplatte ist, insbesondere zur konvektiven Ableitung von Wärme mittels der Luftverbindung an die Kühlplatte. Von Vorteil ist dabei, dass mittels der dem jeweiligen Wärme erzeugenden Bauelement beziehungsweise dem zugehörigen Oberflächenberiech der Leiterplatte zugeordneten Ausnehmung im Kunststoffkörper ein Luftraumbereich geschaffen ist, der zumindest teilweise von einem Oberflächenbereich der Kühlplatte begrenzt wird und von einem jeweiligen Wärme erzeugenden Bauelement beziehungsweise von dem hierzu zugehörigen Oberflächenbereich der Leiterplatte. Somit bildet sich bei Temperaturdifferenzen konvektiv angetriebene Luftströmung aus, so dass eine Wärmeabfuhr an die Kühlplatte ermöglicht ist.

Bei einer vorteilhaften Ausgestaltung ist eine erste Seite der Leiterplatte oder zumindest ein Teilbereich dieser Seite, insbesondere lückenlos, bedeckt, also abgedeckt von dem Kunststoffkörper, insbesondere von dessen erstem Teilkörper, und
die andere Seite der Leiterplatte ist zumindest teilweise bedeckt, also abgedeckt, von dem Kunststoffkörper, insbesondere von dessen zweitem Teilkörper, insbesondere wobei der zweite Teilkörper ringförmig ausgebildet ist. Von Vorteil ist dabei, dass die abgedeckten auf der Leiterplatte bestückten Bauelemente geschützt sind vor Umwelteinflüssen, wie beispielsweise mechanischer Krafteinwirkung. Der Kunststoffkörper führt also gehäusebildende Funktionen aus - soweit die Bedeckung sich erstreckt. Dabei ist er allerdings elastischer als ein Aluminiumgehäuse. Erst nach Einbau in das topfförmige Gehäuseteil und Verschließen desselben mit dem Deckelteil ist ein vollständiges Gehäuse geschaffen. In diesem eingebauten Zustand übernimmt der Kunststoffkörper dann auch Wärme ableitende Funktion beziehungswiese schafft Luftraumbereiche zur gezielten Entwärmung von Wärme erzeugenden Bauelementen, wenn seine Wärmeleitfähigkeit geringer als die von Luft ist.

Bei einer vorteilhaften Ausgestaltung weist das Gehäuse des Geräts ein topfförmiges Gehäuseteil auf, das von einem Deckelteil verschlossen ist,
insbesondere wobei an der Innenwandung des topfförmigen Gehäuseteils eine Kontaktfläche zur Wärmeeinleitung von der Kühlplatte ans Gehäuse angeordnet ist. Von Vorteil ist dabei, dass die von der Kühlplatte ans Gehäuse eingeleitete Wärme aufspreizbar ist über das ganze topfförmige Gehäuseteil. Somit verteilt sich die Wärme auf eine große Oberfläche. Dabei ist allerdings die Kontaktfläche zur Kühlplatte in möglichst guten Wärmekontakt zu bringen. Da die Kühlplatte selbst schon flächig und groß, insbesondere vergleichbar mit der ganzen Leiterplatte, ausführbar ist, ist ein hinreichender Wärmeübergang einfach herstellbar, insbesondere sogar ohne Wärmeleitpaste im Kontaktbereich. Der Einbau der Kassette, bestehend aus Kühlplatte, Kunststoffkörper und Leiterplatte, in das topfförmige Gehäuse ermöglicht auch das Herstellen von verschiedenen Varianten in einfacher Weise. Denn stets dieselbe Kassette ist in verschiedene Gehäuseteile einbaubar. Somit sind applikationsspezifische oder marktspezifische Besonderheiten durch entsprechend Modifizierte Gehäuseteile abdeckbar. Die Deckelteil sind entsprechend variierbar. Eine hohe Varianz ist mit einer geringen Anzahl von Bauteilen erzeugbar.

Bei einer vorteilhaften Ausgestaltung sind zwischen Deckelteil und Gehäuseteil Kabeldurchführungen angeordnet, insbesondere für Versorgungsleitungen, einen Verbraucher speisenden Leitungen und Datenbusleitungen. Von Vorteil ist dabei, dass das topfförmige Gehäuse mit möglichst tief liegendem Boden ausführbar ist, also mit hohen Topfseitenwänden.

Wichtige Merkmale bei dem Verfahren zum Herstellen eines elektrischen Geräts sind, dass das Gerät eine zumindest mit einem Leistungsmodul und weiteren Bauteilen bestückte Leiterplatte aufweist, insbesondere wobei die Bauteile und das Leistungsmodul somit auf der Leiterplatte befestigt sind,
wobei
(i) in einem Verfahrensschritt die Leiterplatte zumindest teilweise mit einem Kunststoffkörper umschlossen wird, insbesondere
   - mit Kunststoff zumindest teilweise umspritzt wird zur Bildung des Kunststoffkörpers
   - oder zwischen mindestens zwei Teilkörper des zumindest zweistückig ausgebildeten Kunststoffkörpers eingelegt wird, wobei die Teilkörper nach dem Einlegen miteinander verbunden werden, insbesondere formschlüssig und/oder mittels Verrastung,
(ii) in einem nachfolgenden Verfahrensschritt eine Kühlplatte mit dem Leistungsmodul verbunden, insbesondere schraubverbunden, wird,
(iii) in einem weiter nachfolgenden Verfahrensschritt die Leiterplatte samt Kühlplatte und Kunststoffkörper in ein topfförmiges Gehäuseteil eingeschoben wird und die Kühlplatte an einer Kontaktfläche der Innenwandung des Gehäuseteils angedrückt wird, insbesondere wärmeleitend verbunden wird.

Von Vorteil ist dabei, dass die Leiterplatte von einem schützenden Kunststoffkörper umgeben wird und somit beim Transport und Lagern geschützt ist. Nach Verbinden der Kühlplatte ist der Schutz erhöht und die elektronische Schaltung als Einheit, insbesondere Kassette, transportierbar. Zur Endmontage muss nur die Kassette in das topfförmige Gehäuse eingeschoben werden und mit ihrer Kühlplatte in Kontakt gebracht werden zur Wärmeableitung ans topfförmige Gehäuse. Das Gehäuse ist dabei aus Metall, wie beispielsweise Aluminium, damit die Wärme gut abgeleitet wird und eine hohe mechanische Stabilität gehäusebildend eingesetzt wird.

Weitere Vorteile ergeben sich aus den Unteransprüchen.

Die Erfindung wird nun anhand von schematischen Abbildungen näher erläutert:
In der Figur 1 ist ein erfindungsgemäßer Umrichter mit einem ersten und einem zweiten Schaumteil schematisch skizziert.

In der Figur 2 ist die Kontur der Ausnehmung im zweiten Schaumteil 4 gezeigt.

Das Gehäuse des Umrichters weist ein topfförmiges einstückig vorzugsweise aus Aluminium gefertigtes Gehäuseteil 9 auf, das mittels eines Deckelteils 8 verschlossen ist. Im Zwischenbereich zwischen Deckelteil 8 und topfförmigem Gehäuseteil 9 sind Kabeldurchführungen vorgesehen, so dass einerseits Versorgungskabel in den Innenraum einführbar sind und andererseits Verbindungskabel zum vom Umrichter gespeisten Elektromotor, also Verbraucher, herausführbar sind. Außerdem sind auch Datenbuskabel durch eine dortige Kabeldurchführung hindurch in den Innenraum geführt.

Der Elektromotor ist vorzugsweise ein Drehstrommotor. Die Versorgungskabel führen vorzugswiese einphasig oder dreiphasig Netzwechselspannung.

Im Innenraum des Umrichters ist eine Kassette eingeschoben, die die Leiterplatte 12 des Umrichters umfasst und eine Kühlplatte 1.

Auf der Leiterplatte ist die gesamte elektronische Schaltung des Umrichters angeordnet, also Signalelektronik und Leistungselektronik. Dabei gehören zur Leistungselektronik zumindest
- ein Gleichrichter, welcher die mittels der Versorgungskabel zugeführte Wechselspannung gleichrichtet,
- ein Zwischenkreiskondensator zum Glätten der gleichgerichteten Spannung und
- ein Leistungsmodul, welches in Halbbrücken angeordnete Leistungshalbleiterschalter aufweist, von welchen die den Motor speisenden Leitungen gespeist werden.
Die Signalelektronik erzeugt pulsweitenmodulierte Ansteuersignale für die Leistungshalbleiterschalter und ist mit dem Datenbus verbunden.

Die Leiterplatte 12 ist also mit zumindest einem großen Bauteil 3 bestückt wie beispielsweise der Zwischenkreiskondensator und Leistungsmodul 5. Außerdem ist die Leiterplatte 12 auch mit kleinen Bauteilen 11 bestückt, wie SMD-Bauteile.

Das Leistungsmodul 5 ist mittels einer Verbindungsschraube, aufweisend einen Schraubenkopf 7, an eine Kühlplatte 1 angeschraubt, so dass die Wärme des Leistungsmoduls an der Kontaktfläche zur Kühlplatte 1 abführbar ist. Das Leistungsmodul 5 weist als Kontaktfläche eine keramisierte oder mit Kupfer überzogene Kontaktfläche auf. Die Kühlplatte 12 ist vorzugswiese aus Aluminium ausgeführt. Somit ist ein gut wärmeleitender Kontakt herstellbar und die Wärme effektiv abführbar.

Die Kühlplatte weist eine Plattenfläche von mehr als 50%, insbesondere von mehr als 80% oder 90% der Leiterplattenfläche auf. Es ist sogar eine verbesserte Wärmeaufspreizung erreichbar, wenn die Plattenfläche der Kühlplatte 1 die Leiterplattenfläche übersteigt.

Somit ist eine Aufspreizung der vom Leistungsmodul erzeugten Wärme erreicht.

Bei Einführen der Kassette ins topfförmige Gehäuseteil 9 wird die Kühlplatte an die Innenwandung des topfförmigen Gehäuseteils angedrückt, insbesondere zunehmend angedrückt beim Anziehen von entsprechenden Verbindungsschrauben, welche die Verbindung der Kassette mit dem topfförmigen Gehäuseteil 9 bewirken. Somit wird die Wärme von der Kühlplatte 1 dann an das topfförmige Gehäuseteil 9 übertragen und somit aufgespreizt.

Wichtig ist dabei, dass das topfförmige Gehäuseteil die Kassette mit Ausnahme des Deckelteilbereichs umschließt. Somit sitzt die Leiterplatte beidseitig in diesem thermisch ungefähr gleiche Temperatur aufweisenden Gehäuseteil 9. Die Signalelektronik und Leistungselektronik sind also auf gleichem Temperaturniveau.

Die Leiterplatte 12 ist beidseitig von Schaumteilen umgeben, also sozusagen eingepackt. Nur Auf einer Seite ist eine Kühlplatte 1 angeordnet, so dass nur die Leiterplatte 12 nicht aber die Kühlplatte 1 beidseitig eingepackt ist.

Auf der ersten Seite der Leiterplatte ist ein das erste Schaumteil 10 angeordnet. Auf der anderen Seite, also zwischen Kühlplatte 1 und Leiterplatte 12 ist das zweite Schaumteil 4 angeordnet.

Die beiden Schaumteile 4 und 10 sind mittels einer Verrastung verbindbar. Somit umklammern sie sozusagen die Leiterplatte 12.

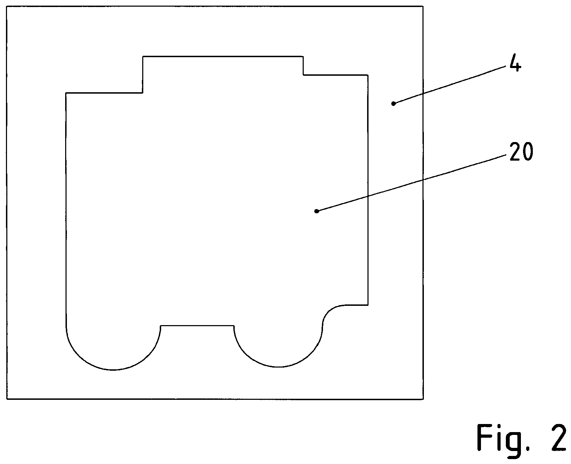

Das zweite Schaumteil 4 weist Ausnehmungen auf, für die großen Bauteile 3 und das Leistungsmodul 5. Da verbleibende Stege aus Stabilitätsgründen eine Mindestwandstärke aufweisen müssen, ergibt sich bei eng angeordneten großen Bauteilen 3 und Leistungsmodul 5 anstatt einzelner voneinander beabstandeter Ausnehmungen im Schaumteil 4 eine einzige große Ausnehmung 20 wie in Figur 2 gezeigt. Somit leitet die in den Zwischenräumen zwischen den großen Bauteilen und innerhalb des zweiten Schaumteils 4 angeordnete Luft Konvektiv Wärme von heißen zu kalten Oberflächenbereichen, insbesondere also zur Kühlplatte 1 hin.

Das zweite Schaumteil 4 ist gemäß Figur 2 als ringförmige Struktur ausgeprägt.

Die Verrastung 2 beziehungsweise 6 der Schaumteile 4 und 10 wird durch deren Ausformung erreicht, ist also ohne zusätzliche Teile ausführbar. Hierbei wird an einem der Schaumteile 4 oder 10 eine Rastnase ausgeformt und am anderen eine entsprechende Ausnehmung mit Rast-Vorsprung. Durch Hintergreifen des Vorsprungs, also Verrastung, ist eine formschlüssige Verbindung herstellbar.

Die Schaumteile 4 und 10 bilden einen Schutz für die Leiterplatte gegen mechanische Einwirkungen, wie Kraftstöße und/oder Schwingungen. Somit ist die Leiterplatte 12 in dieser durch die Schaumteile 4 und 10 gebildeten Verpackung sicher lagerbar und transportierbar.

Außerdem sind je nach Applikation oder Kundenwunsch verschieden geformte topfförmige Gehäuseteile 9 mit der Kassette verbindbar. Ebenso sind verschieden ausgeprägte Deckelteile 8 verbindbar. Auf diese Weise lassen sich also Umrichter mit verschiedenem äußeren Erscheinungsbild und entsprechend verschiedenen Funktionalitäten herstellen, ohne dass die Leiterplatte jedesmal anders ausgeführt werden muss. Wichtig ist dabei nur, dass die Schnittstelle zur Kassette hin kompatibel ist, insbesondere muss die Schnittstelle zur Anbindung der kühlplatte 1 zur Innenwandung des topfförmigen Gehäuseteils 9 eingehalten werden.

Die Verrastung 2 und 6 ist vorzugsweise lösbar ausgeführt.

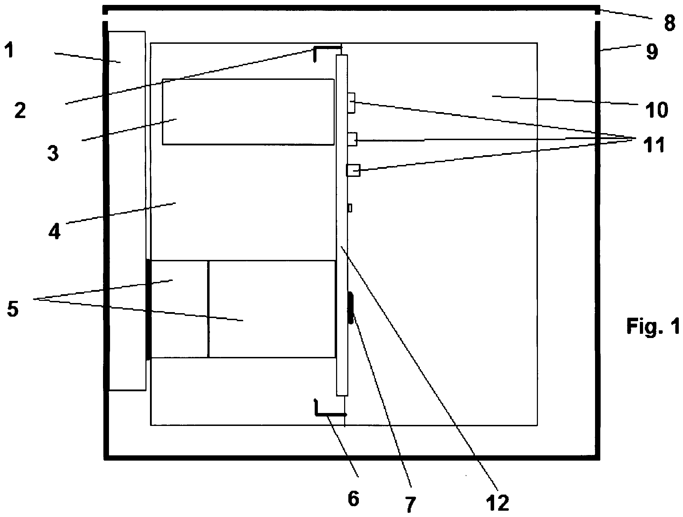

In einem weiteren erfindungsgemäßen Ausführungsbeispiel ist die Beabstandung der großen Bauteile 3 voneinander und vom Leistungsmodul 5 größer als in Figur 1 und 2. Somit weist dann das zweite schaumteil mehrere Ausnehmungen auf, die jeweils deutlich kleiner sind als die in Figur 2 gezeigte Ausnehmung. Dabei werden aber Ausnehmungen derart dimensioniert und angeordnet, dass heiße Wärmequellen durch die in den jeweiligen Ausnehmungen sich ausbildenden konvektiven Luftströmungen zur Kühlplatte 1 hin entwärmt werden. Diese Ausbildung der Ausnehmungen als konvektiv betriebene Luftbereiche ist dann besonders vorteilhaft, wenn die Wärmeleitfähigkeit des Schaumteilwerkstoffs niedriger ist als die von Luft.

Unter Luft ist bei der vorliegenden Erfindung die Umgebungsluft des Umrichters und/oder Luft mit einer Temperatur von 20 ° C bei 1 bar Druck und einer Feuchtigkeit von 30% zu verstehen,

Wenn die Wärmeleitfähigkeit des Schaumteilwerkstoffes diejenige von Luft übersteigt, wird auf die Ausnehmungen für konvektiv betriebene Luftbereiche möglichst verzichtet. Es werden also dann nur Ausnehmungen für die großen Bauteile 3 und das Leistungsmodul 5 vorgesehen.

Als Schaumstoffwerkstoff ist ein Polyurethan verwendbar oder auch Styropor.

In einem weiteren erfindungsgemäßen Ausführungsbeispiel wird die bestückte Leiterplatte 12 nicht mit zwei Schaumteilen mechanisch verbunden sondern es wird ein Schaumteil umspritzend hergestellt oder bei der Styroporherstellung. Hierbei wird die bestückte Leiterplatte mit einem wasserundurchlässigem oder wasserdampfundurchlässigem Lack lackiert, beispielsweise als Tauschlack. In einem weiteren Herstellschritt wird dann die so lackierte Leiterplatte 12 in eine Werkzeugform eingelegt und dann der verbleibende Innenbereich der Form mit Styroporkügelchen befüllt. Durch zusätzliches Einführen von heißem Wasserdampf werden die Styroporkügelchen miteinander formschlüssig verbunden, so dass die Schaumteile 4 und 10 einstückig ausgeformt sind und keine zusätzlichen Ausnehmungen für Luft oder dergleichen enthalten. Dabei ist die Wärmeleitung des entstehenden Styropors durch chemische Zusätze derart verbessert, dass sie besser ist als die von Luft. Statt des Styropors ist auch ein anderer zum Umspritzen geeigneter elektrisch isolierender aber besser als Luft wärmeleitender Werkstoff verwendbar. Je nach Herstellverfahren ist dann die Lackierung mit wasserdampf- oder wasserabweisendem Lack verzichtbar.

Vorzugsweise wird auf Wärmeleitpaste im Kontaktbereich zwischen Kühlplatte und Gehäuseteil verzichtet. Die Fläche ist hierfür genügend groß, so dass die Wärme entsprechend effektiv aufgespreizt ist.

### Bezugszeichenliste

- 1: Kühlplatte
- 2: Verrastung
- 3: großes Bauteil, insbesondere Kondensator
- 4: zweites Schaumteil
- 5: Leistungsmodul, aufweisen Leistungshalbleiterschalter
- 6: Verrastung
- 7: Schraubenkopf einer Verbindungsschraube zum Anschrauben des Leistungsmoduls an die Kühlplatte 1
- 8: Deckelteil
- 9: topfförmiges Gehäuseteil
- 10: erstes Schaumteil
- 11: SMD-Bauteile oder kleine elektronische Bauteile
- 12: Leiterplatte

## Patentansprüche

1. Elektrisches Gerät,
das eine Leiterplatte (12) aufweist, die mit wärmeerzeugenden Bauteilen bestückt ist,
**wobei das Gerät ein Umrichter ist, wobei die Signalelektronik und die Leistungselektronik des Umrichters auf der Leiterplatte (12) angeordnet ist,**
wobei die Leiterplatte (12) in einem Gehäuse des Geräts angeordnet ist,
**wobei** beidseitig der Leiterplatte (12) ein Kunststoffkörper angeordnet ist und mit der bestückten Leiterplatte (12) verbunden ist, insbesondere stoffschlüssig und/oder formschlüssig,
**wobei der Kunststoff als Styropor oder als Schaumstoff, insbesondere als ein Polyurethanschaum, ausgeführt ist,**
**wobei der Kunststoffkörper Ausnehmungen für auf der Leiterplatte (12) bestückte Bauteile (3), insbesondere für große Bauteile, aufweist.**

2. Gerät nach Anspruch 1,
**dadurch gekennzeichnet, dass**
der Kunststoffkörper aus mindestens zwei miteinander formschlüssig verbundenen Teilkörpern zusammengesetzt ist, insbesondere wobei die formschlüssige Verbindung eine Verrastung (2, 6) ist.

3. Gerät nach mindestens einem der vorangegangenen Ansprüche,
**dadurch gekennzeichnet, dass**
der Kunststoffkörper einstückig ausgebildet ist, insbesondere als Umspritzung oder als Kunststoffgussteil hergestellt ist.

4. Gerät nach mindestens einem der vorangegangenen Ansprüche,
**dadurch gekennzeichnet, dass**
die bestückte Leiterplatte (12) an ihrer Oberfläche einen Lack aufweist, insbesondere einen wasserdampfabweisenden Lack und/oder einen wasserabweisenden Lack.

5. Gerät nach mindestens einem der vorangegangenen Ansprüche,
**dadurch gekennzeichnet, dass**
der Kunststoff eine bessere Wärmeleitfähigkeit, insbesondere spezifische Wärmeleitfähigkeit, aufweist als Luft,
insbesondere wobei der Kunststoffkörper aus elektrisch isolierendem Werkstoff gefertigt ist.

6. Gerät nach mindestens einem der vorangegangenen Ansprüche,
**dadurch gekennzeichnet, dass**
auf der Leiterplatte (12) ein Leistungsmodul (5) angeordnet ist, welches mit einer Kühlplatte (1), insbesondere auf eine Aluminium enthaltendes Kühlplatte (1), verbunden ist,
insbesondere auf diese Kühlplatte (1) aufgeschraubt ist und mit dieser wärmeleitend verbunden ist zur Abfuhr von Wärme.

7. Gerät nach mindestens einem der vorangegangenen Ansprüche,
**dadurch gekennzeichnet, dass**
die Kühlplatte (1) außerhalb des Kunststoffkörpers angeordnet ist, insbesondere wobei das Leistungsmodul (5) durch eine Ausnehmung des Kunststoffkörpers hindurchragt.

8. Gerät nach mindestens einem der vorangegangenen Ansprüche,
**dadurch gekennzeichnet, dass**
der Kunststoffkörper, insbesondere der zweite Teilkörper, eine weitere Ausnehmung aufweist, die eine Luftverbindung zwischen einem Wärme erzeugenden, auf der Leiterplatte (12) bestückten Bauelement und einem Oberflächenteilbereich der Kühlplatte (1) ist, insbesondere zur konvektiven Ableitung von Wärme mittels der Luftverbindung an die Kühlplatte (1),
**insbesondere** für auf der Leiterplatte (12) bestückte Bauteile (3), insbesondere für große Bauteile, aufweist.

9. Gerät nach mindestens einem der vorangegangenen Ansprüche,
**dadurch gekennzeichnet, dass**
eine erste Seite der Leiterplatte (12) oder zumindest ein Teilbereich dieser Seite bedeckt, insbesondere lückenlos bedeckt, ist von dem Kunststoffkörper, insbesondere von dessen erstem Teilkörper, und
die andere Seite der Leiterplatte (12) zumindest teilweise bedeckt ist von dem Kunststoffkörper, insbesondere von dessen zweitem Teilkörper, insbesondere wobei der zweite Teilkörper ringförmig ausgebildet ist.

10. Gerät nach mindestens einem der vorangegangenen Ansprüche,
**dadurch gekennzeichnet, dass**
das Gehäuse des Geräts ein topfförmiges Gehäuseteil (9) aufweist, das von einem Deckelteil (8) verschlossen ist,
insbesondere wobei an der Innenwandung des topfförmigen Gehäuseteils (9) eine Kontaktfläche zur Wärmeeinleitung von der Kühlplatte (1) ans Gehäuse angeordnet ist.

11. Gerät nach mindestens einem der vorangegangenen Ansprüche,
**dadurch gekennzeichnet, dass**
zwischen Deckelteil (8) und Gehäuseteil (9) Kabeldurchführungen angeordnet sind, insbesondere für Versorgungsleitungen, einen Verbraucher speisenden Leitungen und Datenbusleitungen.

12. Verfahren zum Herstellen eines Elektrischen Geräts, insbesondere nach mindestens einem der vorangegangenen Ansprüche,
wobei das Gerät eine zumindest mit einem Leistungsmodul (5), **welches in Halbbrücken angeordnete Leistungshalbleiterschalter aufweist,** und weiteren Bauteilen **(3)** bestückte Leiterplatte (12) aufweist, insbesondere wobei die Bauteile **(3)** und das Leistungsmodul (5) somit auf der Leiterplatte (12) befestigt sind,
**dadurch gekennzeichnet, dass**
(i) in einem Verfahrensschritt die Leiterplatte (12) zumindest teilweise mit einem Kunststoffkörper umschlossen wird, **wobei der Kunststoffkörper Ausnehmungen für auf der Leiterplatte (12) bestückte Bauteile (3), insbesondere für große Bauteile, aufweist**
- **wobei der Kunststoffkörper** mit Kunststoff zumindest teilweise umspritzt wird zur Bildung des Kunststoffkörpers
- oder die **bestückte Leiterplatte (12)** zwischen mindestens zwei Teilkörper des zumindest zweistückig ausgebildeten Kunststoffkörpers eingelegt wird, wobei die Teilkörper nach dem Einlegen miteinander verbunden werden, insbesondere formschlüssig und/oder mittels Verrastung (2, 6),
(ii) in einem nachfolgenden Verfahrensschritt eine Kühlplatte (1) mit dem Leistungsmodul (5) verbunden, insbesondere schraubverbunden, wird,
(iii) in einem weiter nachfolgenden Verfahrensschritt die Leiterplatte (12) samt Kühlplatte (1) und Kunststoffkörper in ein topfförmiges Gehäuseteil (9) eingeschoben wird und die Kühlplatte (1) an einer Kontaktfläche der Innenwandung des Gehäuseteils (9) angedrückt wird, insbesondere wärmeleitend verbunden wird,
**wobei der Kunststoff als Styropor oder als Schaumstoff, insbesondere als ein Polyurethanschaum, ausgeführt ist.**

## Claims

1. An electrical device
which has a printed circuit board (12) which is populated with heat-generating components,
wherein the device is a converter, wherein the signal electronics and the power electronics of the converter are arranged on the printed circuit board (12),
wherein the printed circuit board (12) is arranged in a housing of the device,
wherein a plastics-material body is arranged on both sides of the printed circuit board (12) and is connected to the populated printed circuit board (12), in particular by a material bond and/or in positive manner,
wherein the plastics material is embodied as Styropor or as foam material, in particular as a polyurethane foam,
wherein the plastics-material body has openings for components (3) populated on the printed circuit board (12), in particular for large components.

2. A device according to Claim 1,
**characterised in that**
the plastics-material body is composed of at least two partial bodies which are joined together in positive manner, in particular with the positive connection being a latching means (2, 8).

3. A device according to at least one of the preceding claims,
**characterised in that**
the plastics-material body is formed in one piece, in particular as an overmoulding or as a cast plastics-material part.

4. A device according to at least one of the preceding claims,
**characterised in that**
the populated printed circuit board (12) has on its surface a lacquer, in particular a water-vapour-repellent lacquer and/or a water-repellent lacquer.

5. A device according to at least one of the preceding claims,
**characterised in that**
the plastics material has a better thermal conductivity, in particular specific thermal conductivity, than air,
in particular the plastics-material body being manufactured from electrically insulating material.

6. A device according to at least one of the preceding claims,
**characterised in that**
a power module (5) is arranged on the printed circuit board (12), which module is connected to a cooling plate (1), in particular on an aluminium-containing cooling plate (1),
in particular is screwed onto this cooling plate (1) and is connected thereto in thermally conductive manner for dissipating heat.

7. A device according to at least one of the preceding claims,
**characterised in that**
the cooling plate (1) is arranged outside the plastics-material body, with in particular the power module (5) protruding through an opening in the plastics-material body.

8. A device according to at least one of the preceding claims,
**characterised in that**
the plastics-material body, in particular the second partial body, has a further opening which is an air connection between a heat-generating component populated on the printed circuit board (12) and a partial surface region of the cooling plate (1), in particular for dissipating heat by convection by means of the air connection to the cooling plate (1),
in particular [has] for components (3) populated on the printed circuit board (12), in particular for large components.

9. A device according to at least one of the preceding claims,
**characterised in that**
a first side of the printed circuit board (12) or at least a partial region of this side is covered, in particular is covered without gaps, by the plastics-material body, in particular by the first partial body thereof, and
the other side of the printed circuit board (12) is covered at least partially by the plastics-material body, in particular by the second partial body thereof, in particular the second partial body being formed in a ring shape.

10. A device according to at least one of the preceding claims,
**characterised in that**
the housing of the device has a pot-shaped housing part (9) which is closed by a cover part (8),
in particular with a contact surface for introducing heat from the cooling plate (1) to the housing being arranged on the inner wall of the pot-shaped housing part (9).

11. A device according to at least one of the preceding claims,
**characterised in that**
cable bushes are arranged between the cover part (8) and housing part (9),
in particular for supply lines, lines supplying a consumer and data bus lines.

12. A method for producing an electrical device, in particular according to at least one of the preceding claims,
wherein the device has a printed circuit board (12) populated at least with a power module (8) which has power semiconductor switches which are arranged in half-bridges, and with further components (3), in particular wherein the components (3) and the power module (5) are thus fastened to the printed circuit board (12),
**characterised in that**
(i) in one method step the printed circuit board (12) is surrounded at least partially with a plastics-material body, the plastics-material body having openings for components (3) populated on the printed circuit board (12), in particular for large components
- the plastics-material body being at least partially overmoulded with plastics material to form the plastics-material body
- or the populated printed circuit board (12) is placed between at least two partial bodies of the plastics-material body which is formed in at least two parts, the partial bodies, once they have been placed, being connected together, in particular in positive manner and/or by means of latching means (2, 6),
(ii) in a subsequent method step a cooling plate (1) is connected, in particular screw-connected, to the power module (5),
(iii) in a further subsequent method step, the printed circuit board (12) plus cooling plate (1) and plastics-material body is inserted into a pot-shaped housing part (9) and the cooling plate (1) is pressed against a contact surface of the inner wall of the housing part (9), in particular is connected in thermally conductive manner,
wherein the plastics material is embodied as Styropor or as foam material, in particular as a polyurethane foam.

## Revendications

1. Appareil électrique
muni d'une plaquette imprimée (12) garnie de composants générateurs de chaleur,
ledit appareil étant un inverseur, l'électronique de signalisation et l'électronique de puissance dudit inverseur étant situées sur ladite plaquette imprimée (12),
ladite plaquette imprimée (12) étant logée dans un boîtier de l'appareil,
un corps en matière plastique étant disposé des deux côtés de la plaquette imprimée (12) et étant relié à ladite plaquette imprimée garnie (12), notamment par solidarisation matérielle et/ou par complémentarité de formes,
la matière plastique se présentant comme du polystyrène ou comme une mousse, en particulier comme une mousse de polyuréthane,
ledit corps en matière plastique comportant des évidements destinés à des composants (3) mis en place sur ladite plaquette imprimée (12), notamment à des composants de grand dimensionnement.

2. Appareil selon la revendication 1,
**caractérisé par le fait que**
le corps en matière plastique est composé d'au moins deux corps partiels reliés l'un à l'autre par complémentarité de formes, la liaison par complémentarité de formes se présentant notamment comme un encliquetage (2, 6).

3. Appareil selon au moins l'une des revendications précédentes,
**caractérisé par le fait que**
le corps en matière plastique est de réalisation monobloc et est fabriqué, en particulier, comme un enrobage injecté ou comme une pièce moulée en matière plastique.

4. Appareil selon au moins l'une des revendications précédentes,
**caractérisé par le fait que**
la plaquette imprimée garnie (12) présente une laque à sa surface, en particulier une laque repoussant la vapeur d'eau et/ou une laque hydrofuge.

5. Appareil selon au moins l'une des revendications précédentes,
**caractérisé par le fait que**
la matière plastique possède une conductivité thermique, en particulier une conductivité thermique spécifique meilleure que celle de l'air,
le corps en matière plastique étant notamment fabriqué en un matériau électriquement isolant.

6. Appareil selon au moins l'une des revendications précédentes,
**caractérisé par le fait**
**qu'**un module de puissance (5), disposé sur la plaquette imprimée (12), est relié à une platine de refroidissement (1) et notamment à une platine de refroidissement (1) renfermant de l'aluminium,
est notamment vissé sur cette platine de refroidissement (1) et est en liaison thermiquement conductrice avec cette dernière, en vue d'une dissipation de chaleur.

7. Appareil selon au moins l'une des revendications précédentes,
**caractérisé par le fait que**
la platine de refroidissement (1) est placée à l'extérieur du corps en matière plastique, sachant notamment que le module de puissance (5) traverse un évidement dudit corps en matière plastique.

8. Appareil selon au moins l'une des revendications précédentes,
**caractérisé par le fait que**
le corps en matière plastique, en particulier le second corps partiel, est muni d'un évidement supplémentaire instaurant une liaison par circulation d'air entre un composant générateur de chaleur, mis en place sur la plaquette imprimée (12), et une région partielle de la surface de la platine de refroidissement (1), notamment en vue d'évacuer de la chaleur par convection vers ladite platine de refroidissement (1), au moyen de ladite liaison par circulation d'air,
en particulier pour des composants (3) mis en place sur ladite plaquette imprimée (12), notamment des composants de grand dimensionnement.

9. Appareil selon au moins l'une des revendications précédentes,
**caractérisé par le fait**
**qu'**un premier côté de la plaquette imprimée (12), ou au moins une région partielle de ce côté, est recouvert(e), en particulier recouvert(e) sans discontinuité par le corps en matière plastique et notamment par le premier corps partiel de celui-ci, et
l'autre côté de ladite plaquette imprimée (12) est au moins partiellement recouvert par ledit corps en matière plastique, en particulier par le second corps partiel de ce dernier, sachant notamment que ledit second corps partiel est de réalisation annulaire.

10. Appareil selon au moins l'une des revendications précédentes,
**caractérisé par le fait que**
le boîtier dudit appareil comporte une partie (9) configurée en un pot et obturée par une partie (8) formant couvercle,
sachant notamment qu'une surface de contact est située sur la paroi intérieure de ladite partie (9) du boîtier configurée en un pot, en vue d'une introduction de chaleur gagnant ledit boîtier à partir de la platine de refroidissement (1).

11. Appareil selon au moins l'une des revendications précédentes, **caractérisé par le fait que**
des traversées de câbles sont interposées entre la partie (8) formant couvercle et la partie (9) du boîtier, en particulier pour des conducteurs d'alimentation, des conducteurs alimentant un appareil consommateur, et des lignes de bus de données.

12. Procédé de fabrication d'un appareil électrique notamment conforme à au moins l'une des revendications précédentes,
ledit appareil présentant une plaquette imprimée (12) garnie d'au moins un module de puissance (5) comportant des commutateurs à semi-conducteurs de puissance agencés en des demi-ponts, et de composants supplémentaires (3), sachant notamment que lesdits composants (3) et ledit module de puissance (5) sont ainsi fixés sur ladite plaquette imprimée (12),
**caractérisé par le fait que**
(i) au cours d'une étape opératoire, la plaquette imprimée (12) est au moins partiellement entourée d'un corps en matière plastique, lequel corps en matière plastique comporte des évidements destinés à des composants (3) mis en place sur ladite plaquette imprimée (12), notamment à des composants de grand dimensionnement,
- sachant que le corps en matière plastique est au moins partiellement enrobé de matière plastique, par injection, afin de former ledit corps en matière plastique,
- ou que la plaquette imprimée garnie (12) est intégrée entre au moins deux corps partiels dudit corps en matière plastique réalisé en au moins deux parties, lesdits corps partiels étant reliés l'un à l'autre à l'issue de l'intégration, notamment par complémentarité de formes et/ou par encliquetage (2, 6),
(ii) au cours d'une étape opératoire suivante, une platine de refroidissement (1) est reliée au module de puissance (5), notamment solidarisée par vissage,
(iii) au cours d'une autre étape opératoire successive, ladite plaquette imprimée (12) est insérée, conjointement à ladite platine de refroidissement (1) et audit corps en matière plastique, dans une partie (9) de boîtier configurée en un pot, et ladite platine de refroidissement (1) est pressée contre une surface de contact de la paroi intérieure de ladite partie (9) du boîtier, et est notamment reliée avec conduction thermique,
la matière plastique se présentant comme du polystyrène ou comme une mousse, en particulier comme une mousse de polyuréthane.
